# EUROPÄISCHE PATENTSCHRIFT

(11) **EP 0 756 177 B1**
(45) Veröffentlichungstag und Bekanntmachung des Hinweises auf die Patenterteilung: **23.01.2002**
(21) Anmeldenummer: 96110549.1
(22) Anmeldetag: 29.06.1996
(51) Int. Cl.: G01R 21/133, G01R 35/04

(54) **Einrichtung zum Messen von elektrischer Energie**
Appliance for measuring electrical energy
Dispositif pour mesurer l'énergie électrique

(30) Priorität: 22.07.1995 DE 19526870
(43) Veröffentlichungstag der Anmeldung: 29.01.1997
(73) Patentinhaber: Industrie-Technik Fröschl GmbH, 93194 Walderbach (DE)
(72) Erfinder: Zintl, Peter, 93092 Friesheim/Barbing (DE)
(74) Vertreter: Graf, Helmut, Dipl.-Ing.

(56) Entgegenhaltungen:
- EP-A- 0 315 834
- EP-A- 0 355 559
- EP-A- 0 360 511
- DE-A- 3 743 064

## Beschreibung

Die Erfindung geht aus von einer Einrichtung zum Messen des Verbrauchs an elektrischer Energie gemäß Oberbegriff des Patentanspruchs 1.

Zähler zur Messung der elektrischen Energie sind in unterschiedlichen Ausführungen bekannt. Weiterhin sind auch unterschiedlichste Meßverfahren zur Erfassung der elektrischen Energie möglich und bekannt, beispielsweise das Induktionsmeßprinzip, das Meßprinzip mit Hallsensor, das Meßverfahren mit Time-Division-Multiplikation sowie digitale Meßverfahren, bei denen mit Hilfe eines Mikroprozessors aus digitalen Meßsignalen, die den Meßgrößen Strom und Spannung entsprechen, die elektrische Energie ermittelt wird.

Zumindest nach den derzeitigen Bestimmungen muß jeder Zähler, der im geschäftlichen Verkehr zur Ermittlung des Verbrauchs an elektrischer Energie eingesetzt wird, nach dem Eichgesetz geeicht werden. Eichfähig sind solche Zähler, die über eine Bauart-Zulassung durch die Physikalisch Technische Bundesanstalt verfügen. Neben technischen Kriterien regelt die Bauzulassung auch die Eichgültigkeitsdauer eines Zählers, die nach den heutigen Regelungen für die nach dem Induktionsmeßprinzip arbeitenden Zähler (Ferraris-Zähler) bei sechzehn Jahren und bei nach dem Hallsensor-Meßprinzip arbeitenden Zählern bei etwa acht Jahren liegt. Die Eichgültigkeitsdauer ist entsprechend der zu erwartenden, technologisch bedingten zeitlichen Veränderungen der Meßeinrichtung bzw. des Meßwerkes des Zählers festgelegt.

Bekannt ist zum Messen des Verbrauchs an elektrischer Energie (EP-A-360 511) eine Einrichtung, bei der ein Ferraris-Zähler zwei unabhängige Impulsgeber aufweist, die demselben Verbrauch proportionale Impulssignale an zwei getrennte Kanäle einer Elektronik liefern. Zur Überwachung der Impulsgeber und der Übertragung der Impulssignale werden diese in der Elektronik verglichen. Durch Alterung bedingte Fehler am Zähler selbst können mit dieser bekannten Einrichtung zuverlässig nicht erfaßt werden.

Bekannt ist ferner, anstelle der unabhängigen Impulsgeber zwei unabhängige Zähler vorzusehen, die den selben Verbrauch messen und von diesem Verbrauch abhängig Impulssignale liefern. Gleichartige Impulssignale, die von unterschiedlichen Zählern stammen, werden u.a. zur Überwachung der Zähler in einer zugehörigen Elektronik verglichen. Durch Alterung bedingte Fehler, die in beiden Zählen systembedingt gleichermaßen und mit gleicher Tendenz oder Wirkung auftreten, können mit dieser bekannten Einrichtung zuverlässig nicht erfaßt werden.

Bekannt ist weiterhin eine Zähleranordnung mit zwei Zählern zur getrennten Erfassung des Verbrauchs von zwei Verbrauchergruppen (EP-A-0 315 834). Eine erste der beiden Verbrauchergruppen wird nur während einer Tarifphase betrieben. Die zweite Verbrauchergruppe ist über eine Reihenschaltung beider Zähler mit dem Versorgungsnetz verbunden. Die erste Verbrauchergruppe ist nur über einen Zähler mit dem Versorgungsnetz verbunden, so daß durch Vergleich der Zählerstände eine Funktionskontrolle beider nach verschiedenen Meßprinzipien arbeitenden Zähler möglich ist. Es handelt sich um eine Anordnung von mehreren Zählern. Bei gleicher Ausbildung dieser Zähler und deren Meßwerke können diese in einem Gehäuse untergebracht werden, aber durch Alterung des Meßwerks bedingte Fehler bei der Verbrauchsmessung sind nicht feststellbar.

Aufgabe der Erfindung ist es, eine Einrichtung zum Messen des Verbrauches an elektrischer Energie aufzuzeigen, die (Einrichtung) über eine lange Zeitdauer eine genaue Messung ermöglicht und Fehler bei dieser Verbrauchsmessung besser erkennen läßt. Zur Lösung dieser Aufgabe ist eine Einrichtung entsprechend dem Patentanspruch 1 ausgebildet.

Bei der Erfindung, bei der die beiden Module und die Meß- Elektronik Bestandteil eines einzigen Zählers sind, werden für ein und dieselbe Verbrauchsmessung wenigstens zwei Meßmodule verwendet, die jeweils nach einem unterschiedlichen Meßprinzip arbeiten und von denen ein Meßmodul ein nach dem Hall-Prinzip arbeitendes Modul und das andere Meßmodul ein nach dem Digital-Meßverfahren arbeitendes Modul ist, d.h. ein Modul, welches Strom und Spannung in Eingangsstufen erfaßt und einem Ditital-Analog-Wandler der Meßelektronik zuführt.

Hierdurch ergibt sich ein redundantes System mit der Möglichkeit einer Selbstüberwachung und einer zusätzlichen Fehleranzeige und/oder -meldung dann, wenn die von beiden Meßmodulen gelieferten Meßwerte über eine vorgegebene Zeitdauer stärker voneinander abweichen, als dies aufgrund eines vorgegebenen Toleranzbereichs bzw. Grenzwertes zugelassen ist.

Beide Meßmodule können besonders zuverlässig und störungsfrei mit der Meßund/oder Auswert-Elektronik zusammenwirken, über die für die Einrichtung bzw. für den Zähler dann insgesamt eine Vielzahl von Features oder Möglichkeiten erreichbar sind, beispielsweise Anzeige der Maximal- und Minimalwerte des Verbrauches in Abhängigkeit von der Zeit, Direktübertragung von Daten aus der jeweiligen Einrichtung an externe Überwachungs- und Anzeigeeinrichtungen, an Einrichtungen zur Erfassung und Auswertung von verrechnungsrelevanten Daten usw., also Features oder Möglichkeiten, die ein rein elektromechanisch arbeitende, aber bewährte Ferraris-Zähler nicht besitzt.

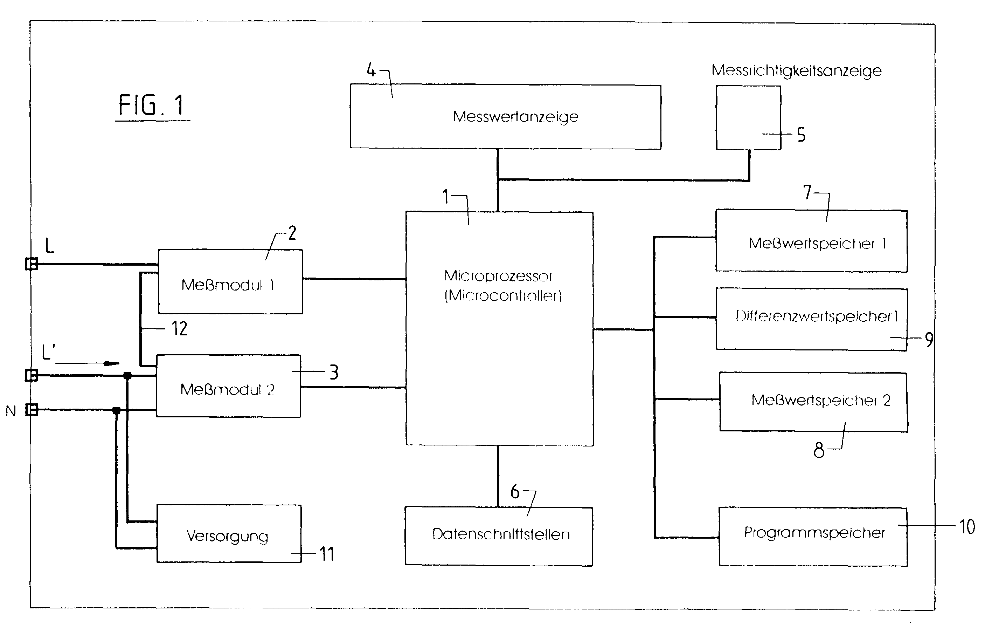

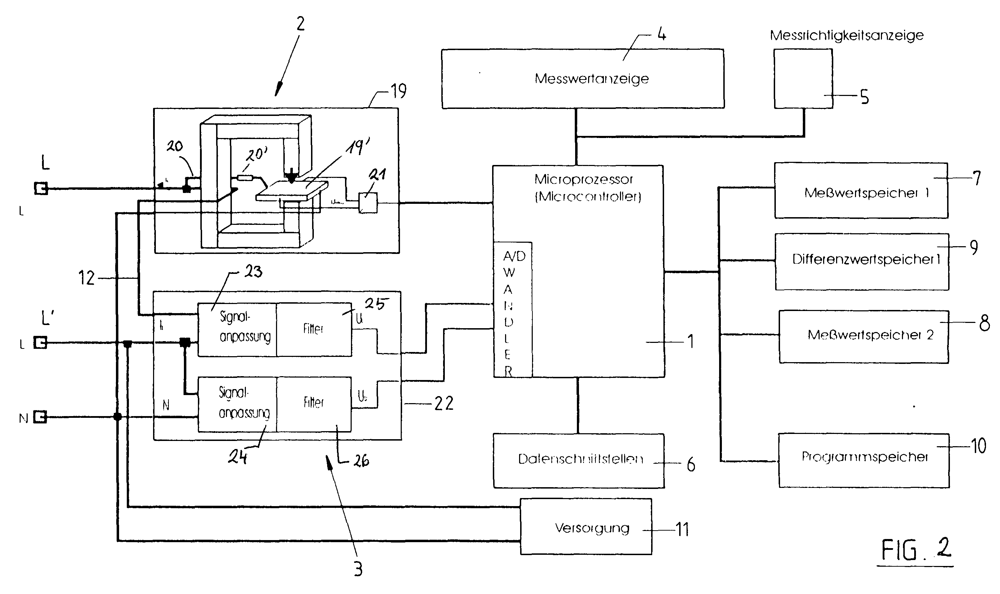

Weiterbildungen der Erfindung sind Gegenstand der Unteransprüche. Die Erfindung wird im Folgenden anhand der beiden Figuren 1 und 2, die jeweils in vereinfachter Darstellung und im Blockdiagramm den erfindungsgemäßen Zähler wiedergeben, erläutert.

Die Fig. 1 zeigt die grundsätzliche Ausbildung einer erfindungsgemäßen Einrichtung zum Messen von elektrischer Energie in Form eines Zählers. Zentrales Element dieses Zählers ist ein Mikroprozessor 1, welchem folgende Elemente bzw. Module zugeordnet sind:
Ein erstes Meßmodul 2,
ein zweites Meßmodul 3,
eine Meßwertanzeige 4,
eine Meßrichtigkeitsanzeige 5,
eine, wenigstens eine Schnittstelle aufweisende Datenschnittstellenanordnung 6,
ein erster Meßwertspeicher 7,
ein zweiter Meßwertspeicher 8,
ein Differenzwertspeicher 9 sowie
ein Programmspeicher 10.

Die beiden Meßwertspeicher 7 und 8 sowie der Differenzwertspeicher 9, die selbstverständlich baulich auch als ein Bauelement oder eine Baugruppe ausgeführt sein können, sind Schreib-Lese-Speicher. Der Programmspeicher, der das Programm für den Mikroprozessor 1 enthält, ist bevorzugt ein Festspeicher (ROM). Mit 11 ist in der Fig. 1 noch eine Spannungsversorgung für die beiden Meßmodule 2 und 3 bezeichnet.

Die beiden Meßmodule 2 und 3 dienen zum Messen der elektrischen Energie, die von einem Stromkunden, beispielsweise einem industriellen Großabnehmer oder aber von einem Haushalt verbraucht wird, d.h. die beiden Meßmodule 1 und 2 setzen diese verbrauchsrelevanten Daten (Produkt aus Spannung und Strom unter Berücksichtigung der Phasenlage) in elektrische digitale Signale um, die dem Mikroprozessor 1 zugeführt werden.

Die Besonderheit besteht dabei darin, daß die beiden Meßmodule 2 und 3 den gleichen Verbrauch erfassen und es sich bei diesen Meßmodulen 2 und 3 aber jeweils um Module handelt, die auf unterschiedliche Meßverfahren basieren, wobei das Meßmodul 2 nach dem Hallmeßprinzip arbeitet und das Meßmodul 3 auf einem rein elektronischen Meßverfahren beruht, wie dies nachfolgend anhand der Figur 2 noch näher erläutert wird.

Die von den beiden Meßmodulen 2 und 3 gelieferten Meßwerte werden dem Mikroprozessor 1 zugeführt, der u.a. eine getrennte Speicherung dieser verrechnungsrelevanten Werte in dem Meßwertspeicher 7 (für Meßmodul 2) bzw. in dem Meßwertspeicher 8 (für Meßmodul 3) veranlaßt. Weiterhin werden die Meßwerte der Meßmodule 2 und 3 vom Mikroprozessor 1 ständig verglichen und die hierbei ermittelten Differenzwerte werden in dem als Ringspeicher organisierten Differenzspeicher 9 abgelegt.

Auf der Meßwertanzeige 4 können ständig oder auch erst auf Aufforderung hin die verrechnungsrelevanten Werte aus dem Meßwertspeicher 7 und/oder 8 angezeigt werden.

Die Speicherung der Meßwerte in den Meßwertspeichern 7 und 8 erfolgt bevorzugt nach einem Sicherungsverfahren, welches die Datensicherheit, d.h. die Abspeicherung von verfälschten Daten nach Möglichkeit ausschließt, vorzugsweise mit Paritäts- und Check-Summenbildung. Datenverfälschungen aufgrund von Störungen, beispielsweise aufgrund von hochfrequenten, auf der Leitung vorhandenen Netzstörungen treten dann z.B. nicht mit sehr hoher Wahrscheinlichkeit jeweils an der gleichen Speicherstelle der Meßwertspeicher 7 und 8 auf, so daß durch eine redundante Speicherung die Datensicherheit wesentlich erhöht wird. Der jeweilige Wert mit korrektem Paritäts- und Check-Summenergebnis wird dann als "richtiger Wert" für die Verrechnung herangezogen.

Um eine dauerhafte Abweichung der Meßergebnisse bzw. eine Störung eines Meßmoduls 2 bzw. 3 sicher zu erfassen, wird aus den durch die Differenzbildung der Meßergebnisse der Meßmodule 2 und 3 gewonnenen Differenzwerte vom Mikroprozessor 1 ein Mittelwert gebildet und dieser Mittelwert periodisch mit einem festgelegten Grenz- bzw. Schwellwert verglichen. Wird der vorgegebene Grenzwert überschritten, so veranlaßt der Mikroprozessor 1 eine entsprechende optische Anzeige an der Meßrichtigkeitsanzeige 5 als optischer Hinweis dafür, daß ein Austausch des betreffenden Zählers notwendig, zumindest jedoch angebracht ist.

Über die Datenschnittstelleneinrichtung 6 können die vorgenannten Daten und Informationen, insbesondere auch die in den Meßwertspeichern 7 und 8 und in dem Differenzspeicher 9 abgespeicherten Daten an räumlich von dem Zähler entfernt vorgesehene weitere Meß- und/oder Überwachungseinrichtungen oder an eine Zentrale usw. weitergeleitet werden, insbesondere auch zusammen mit einem Signal, welches das Überschreiten des vorgenannten Schwell- bzw. Grenzwertes bei der Mittelwertbildung der Differenz zwischen den beiden Meßwerten der Meßmodule 2 und 3 anzeigt.

Der Mikroprozessor 1 hat auch die Funktion einer Echtzeituhr. Die Anschlüsse der Meßmodule 2 und 3 sind in der Fig. 1 mit L, L' und N bezeichnet, wobei N der Anschluß für den Null-Leiter und L und L' die beiden Anschlüsse des Zählers für eine Phase sind. Die beiden Meßmodule 2 und 3 sind zählerintern miteinander verbunden, wie dies mit der Leitung 12 in der Fig. 1 angedeutet ist, und zwar derart, daß die beiden Meßmodule 2 und 3 in Serie parallel zu den Anschlüssen L und L' liegen, über die die Phase der zum Verbraucher führenden Leitung durch den Zähler hindurchgeschleift ist.

Der erfindungsgemäße Zähler weist u.a. folgende Vorteile auf:

Eine pauschale zeitliche Begrenzung der Eichgültigkeit des Zählers ist nicht mehr notwendig, da Abweichungen, die beispielsweise durch Alterungserscheinungen und/oder Defekte in einem Meßmodul 2 oder 3 auftreten, sicher erfaßt und zu einer Aktivierung der Meßrichtigkeitsanzeige 5 und/oder zur Übermittlung einer entsprechenden Fehlermeldung an eine zentrale Überwachungsstelle führen, d.h. die Meßwertabweichung wird als meßtechnisches Kriterium für die Richtigkeit und Eichgültigkeitsdauer verwendet.

Es erfolgt eine redundante Registrierung der Meßwerte. Bei störungsbedingten Veränderungen eines Meßwertes kann der redundant gespeicherte richtige Wert durch geeignete Auswertverfahren usw. zur Verrechnung verwendet werden.

Der Kunde und auch der Betreiber erhalten durch die Anzeige der Meßrichtigkeit eine zusätzliche Sicherheit bezüglich der ordnungsgemäßen Arbeitsweise des Zählers.

Durch die Verwendung des Mikroprozessors 1 sind eine Vielzahl von zusätzlichen Feature für den Zähler möglich. So ist beispielsweise das oben bereits erwähnte Auslesen von Daten über die Datenschnittstellenanordnung 6 und die Übertragen dieser Daten an eine zentrale Überwachungs- und Meßstelle möglich, und zwar nicht nur der verbrauchs- oder verrechnungsrelevanten Daten, sondern auch zugehöriger Zeitdaten, so daß z.B. auch die Ermittlung des maximalen und minimalen Verbrauchs und der zugehörigen Zeiten möglich ist. Weiterhin ist über die Datenschnittstellenanordnung 6 auch die Übertragung von Steuerbefehlen an den jeweiligen Zähler möglich.

Bei der in der Fig. 2 wiedergegebenen Ausführung ist das Meßmodul 2 ein Modul 19, welches nach einem Meßverfahren mit einem Hallsensor 19' arbeitet. Durch eine Stromspule 20 mit zugehörigem Kern wird ein vom Strom abhängiges, den Hallsensor durchsetzendes Magnetfeld erzeugt. Über einen Vorwiderstand 20' sind zwei Elektroden des Hallsensors 19' mit der anliegenden Netzspannung beaufschlagt. Die an den beiden anderen Elektroden des Hallsensors 19' anliegende Hallspannung U_{Hall} ist dann proportional zu dem Produkt der Meßgrößen Strom und Spannung.

Dem Hallsensor 19' ist ein Spannungs-Frequenz-Wandler 21 nachgeschaltet, der aus der Hallspannung ein Frequenzsignal, d.h. eine Impulsfolge bildet, deren Impulsfolgefrequenz abhängig von der Hallspannung und damit abhängig von dem Produkt aus Strom und Spannung ist. Auch dieses dem Mikroprozessor 1 zugeführte Meßsignal hat die Wertigkeit "Impulse/kWh".

Für das Meßmodul 3 ist ein Modul 22 verwendet, welches nach einem digitalen Meßverfahren arbeitet. Die Meßgrößen Strom und Spannung werden in Eingangsstufen 23 und 24 angepaßt und über Tiefpaßfilter 25 und 26 einem von dem Mikroprozessor 1 gebildeten Analog-Digital-Wandler zugeführt. Die nach dem Analog-Digital-Wandler vorliegenden digitalen Werte werden vom Mikroprozessor 1 unter Berücksichtigung der Phasenlage multipliziert und weiterverarbeitet.

Die Erfindung wurde voranstehend an einem Ausführungsbeispiel beschrieben. Es versteht sich, daß zahlreiche Änderungen sowie Abwandlungen möglich sind. So können insbesondere auch andere Kombinationen von Meßmodulen 2 und 3 als vorstehend beschrieben, Verwendung finden. Weiterhin wurde der erfindungsgemäße Zähler zur Vereinfachung der Darstellung in einer Zweileiter-Ausführung beschrieben. Es versteht sich, daß dieser Zähler auch als Dreiphasen-Vierleiter-Zähler ausgeführt werden kann.
¹ This term could also be translated as "Hall sensor" - *Translator's note.*

## Patentansprüche

1. Einrichtung zum Messen des Verbrauchs an elektrischer Energie, mit einem ersten Meßmodul (2) und einem zweiten Meßmodul (3), die Bestandteil eines einzigen Zählers sind und die jeweils für ein und denselben Verbrauch relevante Meßwerte aus Strom und Spannung ermitteln, sowie mit einer diesen Meßmodulen zugeordneten Meßelektronik (1, 4 - 10), der die Meßwerte beider Module (2, 3) zur Speicherung und/oder Verarbeitung zugeführt werden, wobei die Meßelektronik Mittel (1) zur Differenzbildung zwischen den Meßwerten der beiden Meßmodule (2, 3) besitzt, **dadurch gekennzeichnet, daß** die beiden Meßmodule (2, 3) zur Ermittlung der Meßwerte jeweils aus Strom und Spannung nach unterschiedlichen Meßprinzipien arbeiten, und **daß** ein Meßmodul (2) ein nach dem Hallsensor-Meßverfahren arbeitendes Modul (19) ist und das andere Meßmodul (3) ein Modul (22) ist, welches Strom und Spannung in Eingangsstufen erfaßt und einem Digital-Analog-Wandler der Meßelektronik zuführt.

2. Einrichtung nach Anspruch 1, **dadurch gekennzeichnet, daß** die Meßwerte beider Meßmodule in der Meßelektronik (1, 4 - 10) angezeigt werden.

3. Einrichtung nach Anspruch 1 oder 2, **dadurch gekennzeichnet, daß** die Meßelektronik (1, 4 - 10) gesonderte Meßwertspeicher (7, 8) zum gesonderten Abspeichern der Meßwerte beider Meßmodule (2, 3) aufweist.

4. Einrichtung nach einem der vorhergehenden Ansprüche, **dadurch gekennzeichnet, daß** in der Meßelektronik ein Differenzwertspeicher (9) zum Abspeichern der bei der Differenzbildung gebildeten Differenzwerte vorgesehen ist.

5. Einrichtung nach einem der vorhergehenden Ansprüche, **dadurch gekennzeichnet, daß** die Meßelektronik Mittel (1) aufweist, um einen Mittelwert der Differenz der Meßwerte der Meßmodule (2, 3) mit einem vorgegebenen Schwellwert zu vergleichen und, um bei Überschreiten dieses Schwellwertes eine Fehlermeldung beispielsweise zur Aktivierung einer optischen Anzeige (5) an der Einrichtung und/oder zur Übermittlung eines entsprechenden Signals an eine von der Einrichtung örtlich getrennte zentrale Meß- und/oder Überwachungsstation zu veranlassen.

6. Einrichtung nach einem der vorhergehenden Ansprüche, **dadurch gekennzeichnet, daß** die Meßelektronik einen Mikroprozessor (1) aufweist, welchem wenigstens ein Meßwertspeicher (7, 8), wenigstens ein vorzugsweise als Ringspeicher ausgebildeter Differenzwertspeicher (9) und wenigstens ein Programmspeicher (10) zugeordnet sind.

7. Einrichtung nach Anspruch 6, **dadurch gekennzeichnet, daß** dem Mikroprozessor (1) eine Meßwertanzeige (4) zur Anzeige der von dem ersten Meßmodul (2) und/oder dem zweiten Meßmodul (3) ermittelten Meßwerte und/oder der entsprechenden in den zugehörigen Meßwertspeichern (7, 8) abgespeicherten Werte sowie die als Meßrichtigkeitsanzeige ausgebildete Anzeige (5) zugeordnet sind.

8. Einrichtung nach einem der vorhergehenden Ansprüche, **gekennzeichnet durch** wenigstens eine Schnittstelle (6) an der Meßelektronik zur Übertragung von Daten und Befehlen.

9. Einrichtung nach einem der vorhergehenden Ansprüche, **dadurch gekennzeichnet, daß** die beiden Meßmodule (2, 3) derart miteinander verknüpft sind, **daß** sie in dem Pfad des zu messenden Stromes in Serie und bezüglich der Spannung parallel liegen.

## Claims

1. Device for measuring the consumption of electrical energy, with a first measurement module (2) and a second measurement module (3) which are constituent parts of a single meter and which, for one and the same consumption, respectively establish relevant measurement values from current and voltage, as well as with a measurement electronics unit (1, 4-10) assigned to these measurement modules, to which the measured values of both modules (2, 3) are supplied for storage and/or processing, wherein the measurement electronics unit has means (1) for difference formation between the measured values of the two measurement modules (2, 3),
**characterised in that**
to determine the measured values respectively from current and voltage, the two measurement modules (2, 3) operate according to different measurement principles, and that one measurement module (2) is a module (19) operating according to the reverberation sensor¹ measuring method, and the other measurement module (3) is a module (22) which records current and voltage in input stages and supplies them to a digital-analog converter of the measurement electronics unit.

2. Device in accordance with claim 1, **characterised in that** the measured values of both measurement modules are displayed in the measurement electronics unit (1, 4-10).

3. Device in accordance with claim 1 or 2, **characterised in that** the measurement electronics unit (1, 4-10) has separate measured value memories (7, 8) for separate storage of the measured values of both measurement modules (2, 3).

4. Device in accordance with one of the preceding claims, **characterised in that** provided in the measurement electronics unit is a difference value memory (9) for storing the differential values formed in difference formation.

5. Device in accordance with one of the preceding claims, **characterised in that** the measurement electronics unit has means (1) for comparing a mean value of the difference of the measured values of the measurement modules (2, 3) with a predetermined threshold value, and where this threshold value is exceeded, for triggering an error message, e.g. for activating an optical display (5) on the device and/or for sending a corresponding signal to a central measuring and/or monitoring station at a separate location from the device.

6. Device in accordance with one of the preceding claims, **characterised in that** the measurement electronics unit has a microprocessor (1), assigned to which are at least one measured value memory (7, 8), at least one differential value memory (9) preferably designed as a ring memory, and at least one program memory (10).

7. Device in accordance with claim 6, **characterised in that** assigned to the microprocessor (1) are a measured value display (4) for displaying the measured values determined by the first measurement module (2) and/or the second measurement module (3) and/or the corresponding values stored in the relevant measured value memories (7, 8), as well as the display (5) designed as a measurement accuracy display.

8. Device in accordance with one of the preceding claims, **characterised by** at least one interface (6) on the measurement electronics unit for transferring data and commands.

9. Device in accordance with one of the preceding claims, **characterised in that** the two measurement modules (2, 3) are linked to one another in such a way that in the path of the current to be measured they lie in series, and in relation to the voltage they lie parallel.

## Revendications

1. Dispositif pour mesurer la consommation en énergie électrique, avec un premier module de mesure (2) et un second module de mesure (3) faisant tous deux partie d'un seul et même compteur et communiquant, pour une seule et même consommation, des valeurs de mesure pertinentes du courant et de la tension, les valeurs de mesure des deux modules (2, 3) étant transmises à un système électronique de mesure connecté à un des modules afin d'être enregistrées et traitées et le système électronique de mesure permettant de représenter le différentiel entre les valeurs de mesure des deux modules (2, 3), et **caractérisé en ce que** les deux modules de mesure (2, 3) destinés à communiquer les valeurs de mesure respectivement du courant et de la tension fonctionnent selon des principes différents, un des modules (2) utilisant le procédé de mesure avec capteur à effet Hall et l'autre l'autre (3) étant un module (22) saisissant le courant et la tension à l'entrée avant de les transmettre à un convertisseur numérique-analogique du système électronique de mesure.

2. Dispositif conforme à la revendication 1, **caractérisé en ce que** les valeurs de mesure des deux modules sont indiquées dans le système électronique de mesure (1, 4 - 10).

3. Dispositif conforme à la revendication 1 ou 2, **caractérisé en ce que** le système électronique de mesure (1, 4 - 10) dispose d'enregistreurs de valeurs de mesure distincts (7, 8) pour permettre un enregistrement séparé des valeurs de mesure des deux modules (2, 3).

4. Dispositif conforme à une des revendications précédentes, **caractérisé en ce qu'**un enregistreur de la valeur différentielle (9) destiné à enregistrer les valeurs différentielles apparaissant lors de la formation de la différence est prévu dans le système électronique de mesure.

5. Dispositif conforme à une des revendications précédentes, **caractérisé en ce que** le système électronique de mesure permet de comparer une valeur moyenne de la différence des valeurs de mesure des modules (2, 3) avec une valeur pivot prédéterminée et de provoquer, en cas de dépassement de cette valeur pivot, l'apparition d'un message d'erreur destiné par exemple à activer une indication (5) optique sur le dispositif et / ou à transmettre un signal approprié à une station de mesure et / ou de supervision séparée du dispositif.

6. Dispositif conforme à une des revendications précédentes, **caractérisé en ce que** le système électronique de mesure est doté d'un microprocesseur (1) auquel sont connectés au moins un enregistreur de valeur de mesure (7, 8), au moins un enregistreur de valeur différentielle (9) conçu de préférence sous la forme d'un enregistreur annulaire et au moins une mémoire programme (10).

7. Dispositif conforme à la revendication 6, **caractérisé en ce que** le microprocesseur (1) est relié à un indicateur de'valeur de mesure (4) indiquant la valeur de mesure communiquée par le premier module de mesure (2) et/ou la valeur de mesure communiquée par le second module de mesure (3) et / ou les valeurs correspondantes enregistrées par les différents enregistreurs de valeurs de mesure (7, 8) ainsi qu'à un indicateur (5) se présentant sous la forme d'un indicateur de la précision de mesure.

8. Dispositif conforme à une des revendications précédentes, **caractérisé par** la présence, sur le système électronique de mesure, d'au moins une interface (6) destinée à la transmission de données et instructions.

9. Dispositif conforme à une des revendications précédentes, **caractérisé en ce que** les deux modules de mesure (2, 3) sont reliés en série dans le chemin du courant à mesurer et parallèlement par rapport à la tension.
